Europäisches Patentamt

**European Patent Office**

**Office européen des brevets**

(11) Numéro de publication: **0 298 546 B1**

# FASCICULE DE BREVET EUROPEEN

(45) Date de publication de fascicule du brevet: **25.03.92**

(51) Int. Cl.5: **H04N 7/137**, H03M 7/42, H04J 3/06

(21) Numéro de dépôt: **88201319.6**

(22) Date de dépôt: **27.06.88**

(54) **Système de transmission de séries d'échantillons numériques codés par des mots binaires à longueurs variables.**

(30) Priorité: **03.07.87 FR 8709446**

(43) Date de publication de la demande:
**11.01.89 Bulletin 89/02**

(45) Mention de la délivrance du brevet:
**25.03.92 Bulletin 92/13**

(84) Etats contractants désignés:
**DE FR GB**

(56) Documents cités:
**WO-A-86/05339**

**SMPTE JOURNAL, vol. 89, juin 1980, pages 451-457, Society of Motion Picture and Television Engineers, Inc., Scarsdale, US; J.O. LIMB et al.: "An interframe coding technique for broadcast television"**

**NEC RESEARCH & DEVELOPMENT, vol. 6, décembre 1963, pages 32-43; Tokyo, JP; T. SEKIMOTO et al.: "Group synchronization for digital transmission systems"**

(73) Titulaire: **TELECOMMUNICATIONS RADIOE-**

**LECTRIOUES ET TELEPHONIOUES T.R.T.
88, rue Brillat Savarin
F-75013 Paris(FR)**

(84) Etats contractants désignés:
**DE GB**

(73) Titulaire: **TRT TELECOMMUNICATIONS RADIOELECTRIOUES ET TELEPHONIOUES
88 rue Brillat Savarin
F-75013 Paris(FR)**

(84) Etats contractants désignés:
**FR**

(72) Inventeur: **Boisson, Jean-Yves
SOCIETE CIVILE S.P.I.D. 209 Rue de l'Université
F-75007 Paris(FR)**
Inventeur: **Bastien, Jean-Paul
SOCIETE CIVILE S.P.I.D. 209 Rue de l'Université
F-75007 Paris(FR)**

(74) Mandataire: **Chaffraix, Jean et al**
**Société Civile S.P.I.D. 156, Boulevard Haus-**
**smann**
**F-75008 Paris(FR)**

## Description

La présente invention concerne un système de transmission de séries d'échantillons numériques codés par des mots binaires à longueurs variables, système formé, d'une part, d'un dispositif émetteur comportant un circuit de codage statistique pour coder en lesdits mots à longueurs variables des mots à longueur fixe se présentant en son entrée sous forme de séries d'échantillons, un circuit de synchronisation pour former des mots de synchronisation définissant la place des mots à longueur variable dans les séries et un circuit multiplexeur pour combiner, en vue de leur transmission les mots de synchronisation avec les mots à longueurs variables et, d'autre part, d'un dispositif récepteur comportant un circuit démultiplexeur pour fournir sur une de ses deux sorties les mots à longueurs variables reçus à un circuit de décodage statistique pour rétablir les mots à longueur fixe et sur l'autre de ses sorties le mot de synchronisation à un circuit de traitement pour rétablir en cas d'erreur de transmission la place des échantillons dans les séries.

Un tel système trouve des applications importantes, notamment pour la transmission, sous forme numérique, d'images de télévision, chaque série d'échantillons représentant alors une ligne de l'image et les échantillons les points d'image (pixels).

Dans le brevet des Etats-Unis d'Amérique US-A-3 971 888 on décrit un système de ce genre pour cette application mentionnée.

Le problème qui se pose avec ce genre de système est sa vulnérabilité aux erreurs de transmission. Une erreur de transmission affecte en premier lieu le mot binaire contenant cette erreur et peut se répercuter sur les mots suivants ; il s'ensuit que, bien que finalement les mots soient reconnus convenablement, ils ne correspondent plus à la place de l'échantillon dans la série. Ce changement de place se propage de ligne en ligne et l'on obtient ainsi une image dont la qualité est fortement dégradée. Le brevet précité, pour résoudre en partie ce problème, préconise d'émettre le mot de synchronisation en début de série et de le protéger par un code correcteur d'erreur. Cependant ces mesures préconisées se révèlent être peu efficaces lorsque surviennent des paquets d'erreurs dont la durée excède celle du mot de synchronisation et dont l'apparition coïncide plus ou moins avec ce mot. Le mot de synchronisation est alors annihilé et il ne peut plus remplir son rôle.

La présente invention propose un système de transmission du genre mentionné dans le préambule, présentant une bonne immunité aux erreurs survenant par paquets.

Pour cela, un tel système est remarquable en ce qu'il est prévu des moyens de commande du circuit multiplexeur pour disséminer dans les séries, les éléments binaires constituant le mot de synchronisation.

La description suivante, en regard des dessins annexés, le tout donné à titre d'exemple non limitatif, fera bien comprendre comment l'invention peut être réalisée.

La figure 1 représente schématiquement un système de transmission conforme à l'invention.

La figure 2 montre des séries d'échantillons à coder.

La figure 3 montre une dissémination possible, conforme à l'invention, des éléments binaires du mot de synchronisation.

La figure 4 représente, en détail, la structure du dispositif émetteur conforme à l'invention.

La figure 5 représente, en détail, un dispositif récepteur conforme à l'invention.

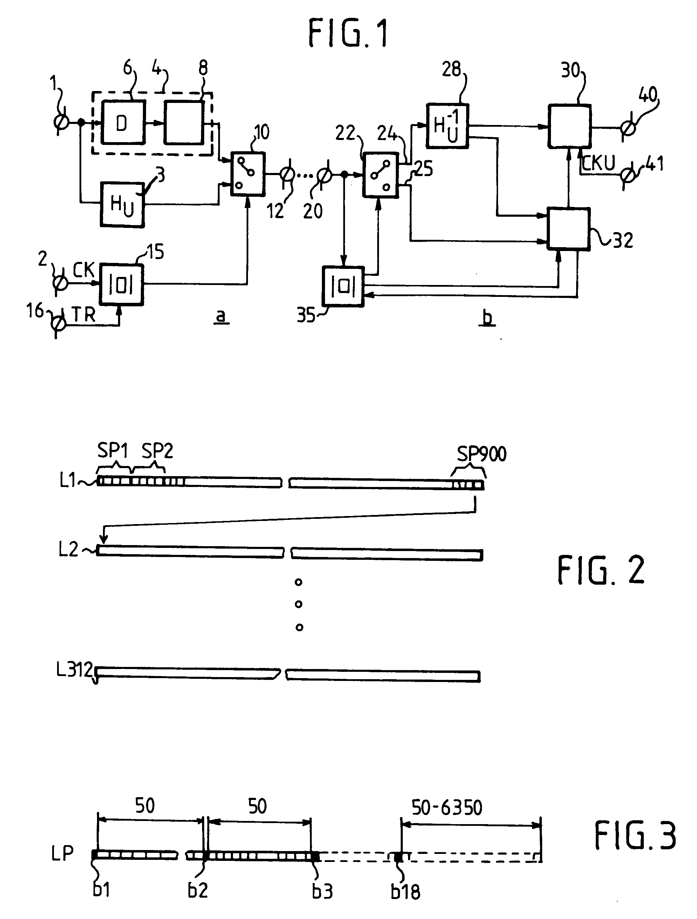

La figure 1 montre le système de l'invention : en a on a représenté le dispositif émetteur et en b le dispositif récepteur. A la borne 1 du dispositif émetteur on applique les échantillons numériques à transmettre. Ceux-ci, formés par des mots de longueur fixe de quatre éléments binaires, se présentent à cette borne, échantillon par échantillon à la cadence d'un signal d'horloge CK appliqué à la borne 2. Comme ces échantillons sont relatifs au codage d'images de télévision, ils se présentent par séries dont chacune est relative à une ligne de l'image. Pour fixer les idées on aura donc 625 séries transmises en deux trames de 312 et 313 lignes.

A la figure 2 on a représenté, bien schématiquement, une trame de 312 lignes L1 ... L312. Chaque ligne est formée d'une série de 900 échantillons SP1 ... SP900 dont 720 représentent la luminance et 180, une information de chrominance. Pour coder ces échantillons selon un code statistique, le dispositif émetteur comporte un circuit de codage 3 effectuant un codage d'Huffmann. Ce codage est décrit notamment au paragraphe 6.2.3.2. page 239 de l'ouvrage intitulé "Digital Image Processing" de R.C.Gonzales et P.Wintz et édité en 1977 par Addison-Wesley Publishing Company. Selon ce code, on affecte des mots de petite longueur (1 élément binaire) aux mots de longueur fixe qui surviennent souvent et des mots de grande longueur (8 éléments binaires) aux mots qui surviennent le plus rarement. Ainsi, selon cet exemple que l'on est en train de décrire, 900 échantillons seront codés pour la transmission par un nombre d'éléments binaires allant de 900 à 7200. A ce nombre, il convient toutefois d'ajouter un certain nombre d'éléments binaires pour assurer la synchronisation de ligne. Pour cela, on a prévu un circuit de synchronisation 4 qui détermine au moyen d'un circuit de mesure 6, la longueur en éléments binaires de chaque ligne (ou série) et qui protège cette mesure au moyen d'un circuit de codage de correction d'erreur 8. Un circuit multiplexeur 10 fournit sur sa sortie 12 les mots binaires à longueur variable combinés avec les mots de synchronisation élaborés par le circuit de synchronisation 4. Le circuit multiplexeur 10 est commandé par une base de temps 15 recevant les signaux CK et initialisé périodiquement par des signaux de fin de trame TR appliqués à la borne 16.

Le dispositif récepteur montré en b reçoit sur sa borne d'entrée 20 la combinaison de mots transmis. Un circuit démultiplexeur 22 fournit à sa première sortie 24 les mots à longueurs variables transmis et à sa deuxième sortie 25 les mots de synchronisation ; à la sortie 24 est connecté un circuit de décodage 28 qui effectue l'opération inverse du circuit de codage 3. Le circuit 28 restitue des mots à longueur fixe à un circuit de mémoire 30 ; à la sortie 25 est connecté un circuit de traitement 32 qui fournit, d'une part, au circuit de mémoire 30 tout un cycle de codes d'adresse correspondant à l'emmagasinage d'une ligne et d'autre part des signaux d'initialisation à une base de temps de réception 35. Cette base de temps 35 est utilisée notamment pour la commande du circuit démultiplexeur 22. C'est à la borne de sortie 40 connectée à la sortie du circuit de mémoire 30 que l'on recueille pour l'utilisation les échantillons transmis au rythme CKU d'une horloge d'utilisation. Les signaux fixant ce rythme sont reçus à une borne 41.

Selon l'invention, pour assurer une efficacité la plus complète au mot de synchronisation, il est prévu des moyens de commande pour disséminer dans les lignes (ou séries) les éléments binaires constituant le mot de synchronisation.

A la figure 3, on a montré une dissémination possible des éléments binaires du mot de synchronisation à l'intérieur d'une série représentant une ligne $L_p$. Le mot de synchronisation formé de 18 éléments binaires y est disséminé à raison d'un élément binaire b1, b2, ..., b18 par paquet de 50 éléments binaires. L'élément binaire b1 étant placé au début de la série, il reste un emplacement allant de 50 à 6350 éléments binaires entre l'élément binaire b18 et la fin de la série et l'on remarque qu'un intervalle minimum de 50 éléments binaires est toujours conservé, ce qui donne une bonne immunité à l'encontre des paquets d'erreurs.

Le mot de synchronisation D est formé d'une part d'un mot D' de 13 éléments binaires pour donner la différence entre la longueur LG en élément binaire de la série à laquelle il est affecté et la longueur moyenne des lignes que l'on a fixée à 2160 de sorte que :

$$D' = LG - 2160 \text{ d'où } -1260 < D' < 5040$$

et d'autre part d'un mot D'' de 5 éléments binaires destiné à protéger le mot D' selon le processus correcteur d'erreurs bien connu de l'homme de l'art et qu'il n'est pas nécessaire de rappeler ici.

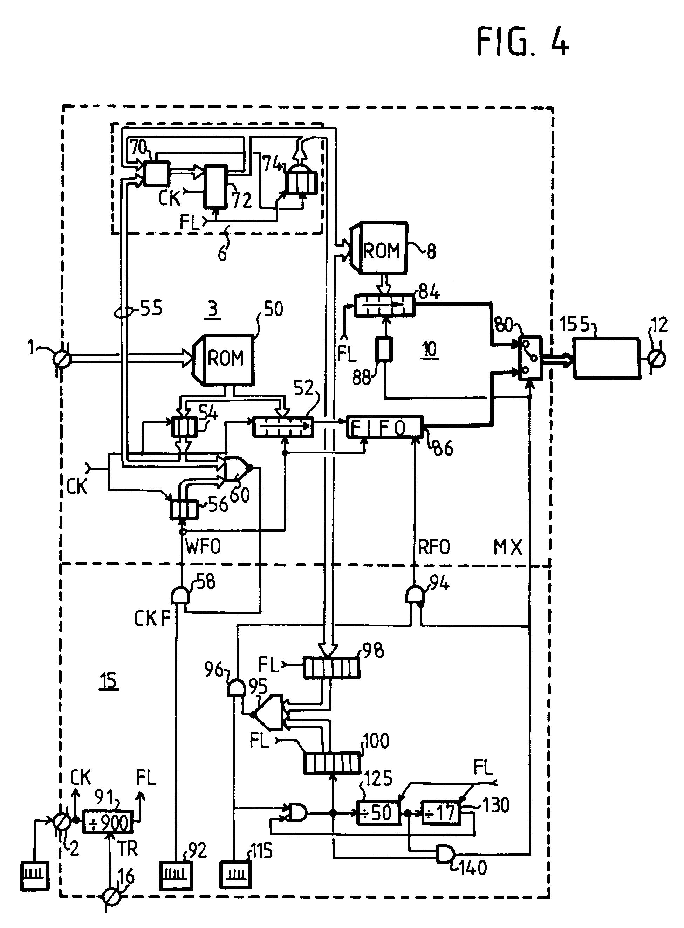

A la figure 4, on a représenté plus en détail la structure du dispositif émetteur.

Le circuit de codage 3 est élaboré autour d'une mémoire morte pré-programmée 50. L'entrée d'adressage de cette mémoire reçoit les échantillons de la borne 1 et à sa sortie on recueille d'une part le code statistique qui est stocké dans un registre à décalage 52 et d'autre part une indication de sa longueur qui est stockée dans un registre 54. Il convient dès à présent de noter que l'information contenue dans le registre 54 va être utilisée par le circuit 6 pour comptabiliser le nombre d'éléments binaires dans une ligne. Pour cela, on a prévu une liaison 55 entre le registre 54 et le circuit 6. Ces registres 52 et 54 sont chargés au rythme du signal CK. Le registre 52 est déchargé par décalage par un signal WFO à un rythme suffisamment rapide pour qu'entre deux apparitions du signal CK actif, le mot à longueur variable le plus long possible contenu dans le registre 52 puisse être décalé complètement. Ce rythme est défini au moyen d'un signal CKF qui est appliqué à un compteur 56 par l'intermédiaire d'une porte ET 58 ; le signal WFO apparaît à la sortie de cette porte. Un comparateur de code 60 compare le contenu du registre 54 avec celui du compteur 56 ; dès qu'il y a égalité, son signal de sortie bloque la porte 58 de sorte que les signaux CKF ne sont plus appliqués au compteur 56 ; puisque le signal de sortie WFO de cette porte est appliqué à la commande de décalage du registre 52, ce registre 52 a été décalé autant de fois qu'indiqué dnas le registre 54. Le compteur 56 est reinitialité chaque fois que le signal CK devient actif.

Comme il vient d'être dit, le circuit de mesure 6 utilise l'information contenue dans le registre 54 afin de pouvoir cumuler ce nombre pour toute une ligne. A cet effet il utilise un accumulateur formé d'un additionneur 70 couplé à un registre d'accumulation 72. L'additionneur 70 somme le contenu des registre 54 et 72 et le résultat s'accumule à chaque apparition du signal actif CK dans le registre 72. Un compteur 74 compte les retenues éventuelles élaborées par l'additionneur 70. Le nombre d'éléments binaires d'une ligne est donc obtenu par le concaténation des contenus du registre 72 et du compteur 74. Un signal FL indiquant une fin de ligne à traiter remet à zéro périodiquement ce registre 72 et le compteur 74. Pour protéger ce nombre par un code correcteur d'erreurs on utilise une mémoire morte judicieusement programmée pour constituer le circuit de codage de correction d'erreur 8.

Le circuit de multiplexage 10 est formé d'un circuit multiplexeur 80 à deux entrées, dont une première est connectée à la sortie d'un registre à décalage 84 effectuant une conversion parallèle-série pour le code provenant du circuit 8 et dont la deuxième entrée est connectée à la sortie d'une mémoire FIFO 86 ; l'entrée de cette mémoire est connectée à la sortie du registre à décalage 52. L'écriture de cette mémoire est effectuée au moyen d'un signal WFO au même rythme, donc, que le décalage de ce registre 52. La lecture s'effectue au rythme d'un signal RFO. La commande du circuit multiplexeur 80 s'effectue par un signal MX, c'est-à-dire que lorsque ce signal est actif, l'élément binaire du registre 84 est transmis à la sortie du circuit 80 puis lorsque ce signal n'est plus actif, ce sont les éléments binaires à la sortie de la mémoire FIFO qui sont transmis. Par suite de la présence d'un circuit de retard 88 connecté à l'entrée de commande de décalage du registre 84 et prévu pour retarder le signal MX, le registre 84 sera décalé d'un cran, peu après que le signal MX soit devenu non actif.

La capacité de la mémoire FIFO 86 doit être suffisante pour contenir plus d'une ligne, c'est-à-dire être supérieure à 7200 éléments binaires ; on doit prélever dans cette mémoire chaque ligne codée entre chaque apparition du signal FL.

La base de temps 15 fournit les différents signaux dont il a été question.

Les signaux CK provenant de la borne 2 restent identiques à eux-mêmes. Les signaux FL proviennent d'un diviseur de fréquence 91 qui divise par 900, correspondant au nombre de points d'image d'une ligne. Ce diviseur est initialisé par le signal TR provenant de la borne 16.

Le signal CKF provient d'un générateur à cadence rapide 92.

Le signal RFO provient de la sortie d'une porte ET 94 dont une entrée est connectée à la sortie d'un circuit comparateur de codes 95 par l'intermédiaire d'une porte ET 96. Ce circuit compare les codes contenus d'une part dans un registre 98 destiné à contenir le nombre d'éléments binaires d'une ligne à transmettre (ce nombre provient de la sortie du circuit 6) et d'autre part dans un compteur 100. Le chargement du registre 98 et l'initialisation du compteur 100 s'effectue par le signal FL actif. Ce compteur 100 s'incrémente au rythme des signaux de sortie d'un générateur de rythme 115 transitant par l'intermédiaire d'une porte ET 118. Les signaux de ce générateur 115 sont appliqués en outre, toujours par l'intermédiaire de la porte ET 118 à un diviseur de fréquence par 50 référencé par 125. Ce taux de division de 50 correspond à l'espacement entre deux éléments binaires du mot de synchronisation (voir figure 3). A la sortie de ce diviseur 125 on a connecté un autre diviseur 130 dont le signal de sortie vient bloquer la porte 118 par l'intermédiaire de l'entrée inverseuse 132 dont elle est munie, lorsque 17 espacements ont été comptés. Ces diviseurs sont initialisés par le signal FL. Une porte ET 140 fournit les signaux MX en direction du circuit 80. Les deux entrées de la porte 140 sont reliées respectivement aux sorties de la porte 118 et du diviseur 125. Un organe de mémoire tampon 155 permet d'adapter le rythme des données fournies à la sortie du circuit 80 avec celui du canal de tansmission connecté en 12. Le fonctionnement de ce genre d'organe 155 peut être compris par la lecture de l'article de Toshio Koga intitulé "Statiscal Performance Analysis of an Interframe Encoder for Broadcast Television Signals" paru dans IEEE COM-29, No.12, DEC 81, page 1868-1876.

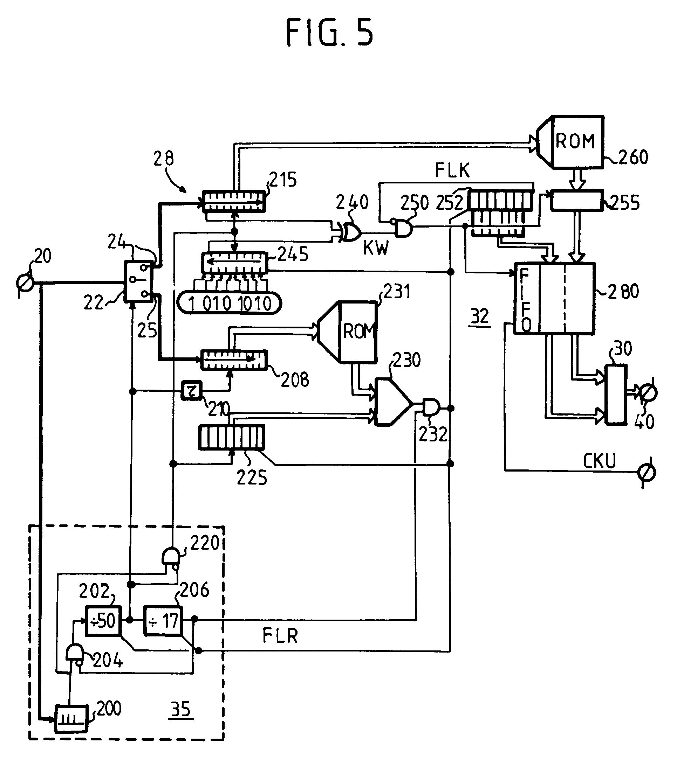

A la figure 5, on a représenté, en détail, un dispositif récepteur. Les données reçues sont appliquées tout d'abord à la base de temps réception 35. Un circuit de restitution d'horloge 200 fournit à partir des signaux reçus un signal dont le rythme est le rythme de transmission du canal. Ce signal est appliqué, d'une manière semblable à celle déjà expliquée pour le dispositif émetteur, à un premier diviseur 202 par l'intermédiaire d'une porte ET 204 munie d'une entrée inverseuse pour être connectée à la sortie d'un deuxième diviseur 206. Ces diviseurs 202 et 206 montés en cascade divisent respectivement par "50" et "17". Le signal de sortie du diviseur 202 commande le circuit démultiplexeur 22 pour que les éléments binaires du mot de synchronisation, reçus, soient emmagasinés dans un registre à décalage 208. Le décalage de ce registre est effectué au moyen du signal de sortie du diviseur 202, signal retardé (d'un court instant par rapport au rythme du circuit 200) par le circuit de retard 210. Les éléments binaires des mots de codes transmis à longueurs variables sont enregistrés dans un registre à décalage 215 au rythme d'un signal fourni par une porte ET 220 dont une entrée est connectée à la sortie du circuit 200 et une autre entrée, inverseuse celle-ci, à la sortie du diviseur 202. On notera que les diviseurs 202 et 206 sont munis d'une entrée d'initialisation recevant un signal FLR. Ce signal actif met à "1" le diviseur 202 et à "0" le diviseur 206. Ce signal FLR est élaboré de la manière suivante. Un compteur 225 compte les impulsions du signal de sortie de la porte 220 et donc les éléments binaires constituant les lignes d'images. Un comparateur de codes 230 compare le code à la sortie d'une mémoire morte 231 qui effectue l'opération ivnerse du codage d'erreurs sur le mot contenu dans le registre 208 avec le code contenu dans le compteur 225 ; le signal de sortie du comparateur est fourni à une porte ET 232 pour être validé par le signal de sortie du diviseur 206 ; on s'assure ainsi que ce signal n'est pris en compte que lorsqu'on est sûr que le mot de synchronisation est complètement emmagasiné dans le registre 208. Le signal de sortie de cette porte 232 constitue le signal FLR qui met à zéro, lorsqu'il est actif, le contenu du compteur 225.

Le fonctionnement du décodeur 28 est basé sur les considérations suivantes. Chaque élément binaire reçu est examiné dans la première case du registre 215 au moyen d'une porte OU-EXCLUSIF 240 délivrant un signal KW. On admet que le mot le plus court est formé du seul élément binaire "1". Cela veut dire que les autres mots commencent par "0", le mot binaire plus long (2 éléments binaires) peut être "00", le mot binaire à 3 éléments binaires peut être "011", le mot binaire à 4 éléments binaires peut être "0100" ... etc. On voit que lorsqu'on charge un mot tel que 10101010 dans un registre à décalage 245 et que l'autre entrée de la porte 240 examine la dernière position du registre 245 et que si le premier élément binaire reçu est "1" il y a coïncidence et le mot est donc reconnu. Si c'est un "0", on décale d'un cran les registres 215 et 245 si le deuxième élément binaire reçu est un "0", le mot binaire "00"" est reconnu et ainsi de suite pour les autres éléments binaires.

Ce signal KW est transmis, par l'intermédiaire d'une porte ET 250 munie d'une entrée inverseuse, d'une part à un compteur 252 pour l'incrémenter, ce compteur étant modulo 900, et d'autre part à la commande de chargement d'un registre 255 connecté en sortie d'une mémoire ROM 260 transcodant les mots reconnus à longueurs variables contenus dans le registre 215 en des mots de longueur fixe. Dès que le compteur 252 a atteint le compte 900 il délivre un signal actif FLK qui, appliqué à l'entrée inverseuse de la porte 250, la bloque et le chargement du registre 255 est interrompu. On notera que le signal FLR provoque le chargement du registre 245 et initialise ainsi le processus de reconnaissance des mots à longueurs variables et que ce signal remet à zéro le compteur 252.

Les contenus du compteur 252 et du registre 255 sont emmagasinés au rythme du signal de sortie de la porte 250 dans une mémoire FIFO 280. Cette mémoire est lue au rythme d'un signal CKU fourni par l'utilisateur, le circuit de mémoire 30 emmagasine les différents codes à longueur fixe aux adresses indiquées par le compteur 252.

On s'aperçoit que le signal FLR synchronise tout le fonctionnement et qu'il a une action prioritaire sur le signal FLK. En fonctionnement normal, ces deux signaux doivent être actifs en même temps.

Si le signal FLK devient actif avant le signal FLR, le compteur 252 et le chargement du registre 255 sont bloqués ; l'apparition du signal FLR remet à zéro le compteur 252 et rend passante ainsi la porte 250, pour que le processus de reconnaissance redémarre.

Si le signal FLR survient avant le signal FLK, quel que soit le contenu du compteur 252, celui-ci est re-initialisé.

## Revendications

1. Système de transmission de séries d'échantillons numériques codés par des mots binaires à longueurs variables, système formé, d'une part, d'un dispositif émetteur comportant un circuit de codage statistique pour coder en lesdits mots à longueurs variables des mots à longueur fixe se présentant en son entrée sous forme de séries d'échantillons, un circuit de synchronisation pour former des mots de synchronisation définissant la place des mots à longueur variable dans les séries et un circuit multiplexeur pour combiner, en vue de leur transmission les mots de synchronisation avec les mots à longueurs variables et, d'autre part, d'un dispositif récepteur comportant un circuit démultiplexeur pour fournir sur une de ses deux sorties les mots à longueurs variables reçus à un circuit de décodage statistique pour rétablir les mots à longueur fixe et sur l'autre de ses sorties le mot de synchronisation à un circuit de traitement pour rétablir en cas d'erreur de transmission la place des échantillons dans les séries, caractérisé en ce qu'il est prévu des moyens de commande du circuit multiplexeur pour disséminer dans les séries, les éléments binaires constituant le mot de synchronisation.

## Claims

1. A system for transmitting sequences of digital samples encoded by variable-length binary words, the system being formed on the one hand by a transmitter device comprising a statistic encoding circuit for encoding, in said variable-length words, words of a fixed length appearing at its input as sample sequences, a synchronizing circuit for forming synchronizing words which define the position of the variable-length words in the sequences and a multiplexer circuit for combining, in view of their transmission, the synchronizing words with the variable-length words, and, on the other hand, a receiver device comprising a demultiplexer circuit for applying from one of its two outputs the received variable-length words to a statistic decoding circuit for recovering the fixed-length words and from its other output the synchronizing word to a processing circuit for recovering, in the event of a transmission error, the position of the samples in the sequence, characterized in that it is provided with control means for the multiplexer circuit for distributing the bits constituting the synchronizing word in the sequences.

**Patentansprüche**

1. System zur Übertragung mittels binärer Wörter veränderlicher Länge kodierter digitaler Abtastfolgen, das einerseits durch eine Sendeeinrichtung mit einem statistischen Kodierkreis zum Kodieren in Form von Folgen von Abtastwerten am Eingang vorhandener Wörter fester Länge in die genannten Wörter veränderlicher Länge, mit einem Synchronisierkreis zum Bilden die Stelle der Wörter veränderlicher Länge in den Reihen bestimmender Synchronisierwörter, sowie mit einem Multiplexerkreis zum in bezug auf die Übertragung Kombinieren der Synchronisierwörter mit den Wörtern veränderlicher Länge, und andererseits durch eine Empfangseinrichtung mit einem Demultiplexerkreis zum an einem der beiden Ausgänge Liefern der an einem statistischen Dekodierkreis erhaltenen Wörter veränderlicher Länge zum Wiederherstellen der Wörter fester Länge und zum an dem anderen der Ausgänge Liefern des an einem Verarbeitungskreis erhaltenen Synchronisierwortes zum im Falle eines Übertragungsfehlers Wiederherstellen der Stelle der Abtastwerte in den Reihen gebildet ist, dadurch gekennzeichnet, daß Steuermittel für den Multiplexerkreis vorgesehen sind um die das Synchronisierwort bildenden Binärelemente in den Reihen zu streuen.

# FIG.1

# FIG. 2

# FIG.3

# FIG. 4

# FIG. 5